# FASCICULE DE BREVET EUROPEEN

(11) **EP 3 105 679 B1**
(45) Date de publication et mention de la délivrance du brevet: **22.11.2017**
(21) Numéro de dépôt: 15702721.0
(22) Date de dépôt: 28.01.2015
(51) Int. Cl.: G06F 11/20, G06F 11/07, G06F 15/173, G06F 9/50

(54) **ENCODAGE DE SCENARIOS DE DEFAILLANCE D'UN PROCESSEUR MANYCORE**
CODIERUNG VON FEHLERSZENARIEN EINES MULTIKERN-PROZESSORS
ENCODING OF FAULT SCENARIOS OF A MANYCORE PROCESSOR

(30) Priorité: 11.02.2014 FR 1451042
(43) Date de publication de la demande: 21.12.2016
(73) Titulaire: Commissariat à l'Énergie Atomique et aux Énergies Alternatives, 75015 Paris (FR)
(72) Inventeur: BENAZOUZ, Mohamed, F-93100 Montreuil (FR)
(74) Mandataire: Hnich-Gasri, Naïma
(86) Numéro de dépôt international: PCT/EP2015/051714
(87) Numéro de publication internationale: WO 2015/121068

(56) Documents cités:
- GB-A- 2 262 175
- AHMAD I ET AL: "Fault-tolerant task management and load re-distribution on massively parallel hypercube systems", PROCEEDINGS OF THE SUPERCOMPUTING CONFERENCE. MINNEAPOLIS, NOV. 16 - 20, 1992; [PROCEEDINGS OF THE SUPERCOMPUTING CONFERENCE], LOS ALAMITOS, IEEE COMP. SOC. PRESS, US, vol. CONF. 5, 16 novembre 1992 (1992-11-16), pages 750-759, XP010026982, DOI: 10.1109/SUPERC.1992.236688 ISBN: 978-0-8186-2630-2
- DUSAN JOKANOVIC ET AL: "DYNAMIC TASK RECONFIGURATION IN THE FAULTY HYPERCUBE MULTIPROCESSOR", IEICE TRANSACTIONS, INSTITUTE OF ELECTRONICS INFORMATION AND COMM. ENG. TOKYO, JP, vol. E74, no. 2, 1 février 1991 (1991-02-01), pages 435-446, XP000230413, ISSN: 0917-1673

## Description

### Domaine de l'invention

L'invention concerne le domaine du calcul parallèle et en particulier celui de l'allocation des ressources de calcul et de communication, c'est-à-dire du placement et du routage des applications logicielles sur des plateformes de calcul monoprocesseur ou multiprocesseurs.

### Etat de la Technique

Un microprocesseur "multi-coeur" ("*multicore*" ou "*multi-core*" en anglais) est un processeur possédant plusieurs coeurs physiques qui travaillent en parallèle. Aujourd'hui les systèmes dits "*manycore*" (ou *"many-core"*) désignent des systèmes comportant des dizaines voire des centaines de coeurs. Ces unités de calcul, qui peuvent être clustérisées ou non, sont interconnectées, par exemple par un réseau de communication (Network on Chip ou NoC).

Lors de la fabrication de ces processeurs ou "puces" manycore, des erreurs peuvent survenir. Il en résulte des processeurs dégradés à différents endroits (emplacement des défaillances) et à différents niveaux (le nombre de défaillances), les parties concernées étant désactivées.

Il est souhaitable de pouvoir commercialiser de tels processeurs dégradés. Plus généralement, il est besoin de méthodes et de systèmes associés permettant d'améliorer le rendement de processeurs manycore (*Yield Enhancement*) à la sortie d'usine, i.e. en permettant d'exploiter (et donc de commercialiser) des processeurs qui ne correspondent pas tout à fait à l'architecture initialement requise.

La plupart des processeurs multi/many-cores actuels utilisent des bus partagé. Ces circuits tendent à supprimer le problème de la reconfiguration en éliminant l'explosion combinatoire des scénarios de pannes possibles. De fait, la littérature brevet ne mentionne aujourd'hui pas même ce problème technique (et a fortiori ne propose pas de solution technique). Cependant, ces circuits à bus partagé ne sont pas extensibles (*scalable*) et les prochaines générations de processeurs *manycore* vont vraisemblablement devoir s'affranchir de ce types de circuits pour adopter des réseaux de communication pour lesquels ce problème technique se posera de façon aigüe.

*Zhang et al. [*Lei Zhang et al. « On Topology Reconfiguration for Defect-Tolerant NoC-Based Homogeneous Manycore Systems » dans IEEE Transactions On Very Large Scale Integration (VLSI) Systems, Vol. 17, No. 9, September 2009*]* divulgue une technique fondée sur la virtualisation pour résoudre le problème de déploiement d'une application sur différentes architectures irrégulières qui résultent de pannes de fabrication d'une même et unique architecture initiale. La virtualisation propose d'unifier toutes ces architectures physiques dégradées sous une seule topologie virtuelle de référence.

Afin d'avoir les ressources de réserve nécessaires à la reconfiguration, cette approche n'offre qu'une partie de la puissance totale réellement présente sur la puce, dégradée soit-elle ou pas (logique dite *AMAD pour As Many As Demand*)*.* Ainsi, il ne peut être défini qu'une seule et unique gamme de puissance. Les processeurs dégradés qui n'offrent pas assez de ressources pour la reconfiguration seront rejetées. Une telle approche n'est efficiente que si elle est appliquée à des architectures *manycore* non clustérisées (en d'autres termes lorsque la redondance est au niveau des coeurs de calcul; le coût associé aux coeurs de réserve étant minimisé). Pour des architectures *manycore* clustérisées (correspondant au cas le plus courant), la redondance au niveau du *cluster* serait trop coûteuse et difficilement rentable. De plus, l'abstraction du NoC physique telle qu'elle est réalisée réduit grandement les possibilités de routage réellement offertes et risque même de réduire l'espace de réalisabilité. De plus, pour l'algorithme adopté de reconfiguration, aucune garantie concernant la possibilité de reconfiguration quelque soit la puce dégradée n'est présentée. En définitive, l'approche proposée par Zhang comporte des limitations. Il est également fait référence à l'article "Fault-tolerant task management and load re-distribution on massively parallel hypercube systems" par Ahmad et Al, dans Proceedings of the Supercomputing Conference, Novembre 16-20, 1992, Minneapolis, USA, IEEE Computer Society Press, vol 5, pages 750-759, qui divulgue un procédé de reconfiguration de tâches logicielles dans un processeur comprenant des unités de calcul interconnecté par un réseau de communication présentant des symétries de topologie, suite à une défaillance d'une ou plusieurs unités de calcul.

La seule approche connue ne constitue donc pas une solution suffisante. Les différentes solutions présentement proposées remédient aux inconvénients connus, au moins en partie.

### Résumé de l'invention

Un procédé et un dispositif pour l'encodage compact de scénarios de panne (ou défaillance) d'un processeur (ou "puce") exploitant les symétries d'interconnexion d'une architecture sont divulgués.
Selon un aspect de l'invention, il est divulgué une méthode de placement et/ou de routage (en anglais *mapping* / *routing*) d'applications sur des processeurs *many-core* dégradés. Les processeurs sont classés dans des gammes. Chaque gamme regroupe des processeurs dont la capacité de calcul est la même, fixée et connue à l'avance, mais dont les emplacements des pannes ne sont connues que lorsque on allume le processeur (i.e. "en ligne"). Les phases de placement/routage sont quant à elles habituellement effectuées "hors-ligne" (par exemple durant la phase de compilation) car très consommatrices en temps et en puissance de calcul. Cette connaissance incomplète de l'architecture à la phase de compilation implique de réitérer le placement/routage pour tous les scénarios de pannes possibles et à sauvegarder les solutions dans un seul binaire afin de faire face à toutes les situations lors du déploiement de l'application sur une gamme donnée. Cependant, le nombre de scénarios possibles par gamme est très grand.

Afin de réduire le nombre de scénarios à traiter, il est avantageux d'exploiter la symétrie des liens d'interconnexion. Ceci revient à comprimer l'espace des scénarios permettant par la même occasion de compresser le binaire et le temps de résolution. Dans un mode de réalisation, il est divulgué une technique de compression (e.g. de réduction) de l'espace des scénarios de pannes par l'exploitation d'une ou plusieurs symétries. Cette compression permet de réitérer les algorithmes de placement/routage sur un nombre comparativement réduit de scénarios de pannes et ainsi de rendre possible l'utilisation de diverses techniques d'exploration, plus ou moins optimisées.

Les solutions de placement/routage pour les scénarios non inclus dans cet ensemble réduit pourront par la suite être obtenues par décompression, laquelle décompression pourra être exécutée au niveau de la puce. Une décompression qui se doit d'être rapide et peu consommatrice en puissance de calcul et en mémoire vu le contexte embarqué.

Avantageusement, aucune limite n'est imposée quant au nombre maximum de pannes. Toutes les processeurs peuvent être exploités, classés dans une gamme et commercialisés. Comparativement aux approches de type AMAD, comme Zhang, le taux de rejet à la sortie d'usine sera donc inférieur selon l'invention (logique dite AMAA pour *As Many As Available*). En d'autres termes, les ressources de calcul présentes sur une puce pourront être pleinement utilisées, en classant les processeurs dégradés dans plusieurs gammes commerciales, par exemple selon le niveau ou nombre de défaillances. Par exemple, si une application n'a pas besoin de la totalité de la puissance offerte par une gamme, elle pourra être déployée sur une gamme inférieure qui sera forcément moins chère et délivrera suffisamment de performance. Par exemple, si une application a besoin de 9 clusters de calculs, on utilisera la gamme à 9 clusters fonctionnels. Il ne sera pas besoin d'utiliser une gamme supérieure à 10, 11 ou 12 clusters (contrairement à la technique de la virtualisation qui aura besoin de plus de clusters pour reconstruire son architecture virtuelle à 9 clusters).

Avantageusement, la symétrie inhérente aux architectures (à travers les liens d'interconnexion entre les unités de calcul) est exploitée.

La symétrie permet d'identifier des cas de pannes équivalents, à quelques opérations de symétrie près. Suivant ces opérations, l'espace des architectures issues d'une même gamme peut être compressé. Dans une étape, les cas équivalents sont détectés et regroupées dans des classes dites d'équivalence. Dans une autre étape les solutions de placement/routage sont calculées (une solution par classe). Généralement après le démarrage du processeur et/ou l'identification du cas de panne et de sa classe, la solution de placement/routage de cette classe peut être décodée/décompressée afin de le reconfigurer.

Avantageusement, la symétrie globale offerte par tous les éléments d'interconnexion est exploitée, et de manière générique. Cette mise en oeuvre est particulièrement délicate et techniquement difficile. Les techniques existantes pour l'exploitation de la symétrie dans des domaines techniques éloignés peuvent recourir à ce des "moteurs d'inférence" pour détecter les cas équivalents. Ces moteurs sont généralement de complexité exponentielle et les optimisations qui leur sont généralement apportées nuisent à leur caractère générique. De plus, la convergence des moteurs d'inférence n'est pas garantie dans le cas général (i.e. temps de calcul non garanti), pas plus que leur exactitude (i.e. des cas équivalents peuvent être répertoriés plusieurs fois car ils n'ont pas été détectés comme tels par le moteur d'inférence).

Avantageusement, l'exploitation de la symétrie qui est proposée est caractérisée par son optimalité (e.g. deux cas équivalents ne sont répertoriés qu'une seule et unique fois), sa rapidité (e.g. associée à une très faible complexité algorithmique) et sa généricité (e.g. elle est facilement adaptable aux différentes architectures).

Avantageusement, il est proposé une nouvelle distance ou norme de distance inter-processeurs (ou inter-clusters), qui tient compte de la symétrie.

Avantageusement, il est proposé une façon d'utiliser cette distance afin de détecter et d'identifier les scénarios équivalents constitue la deuxième nouveauté.

Les prochaines générations de processeurs many-core pourraient bien adopter des NoCs de type "Tore 2D", "Tore 3D" ou autres très riches en symétries. Les modes de réalisation présentement décrits tireraient comparativement avantageusement parti de ces architectures.

Des résultats expérimentaux ont été obtenus. L'approche divulguée a été testée pour un manycore pourvu d'un NoC Tore 2D 4x4 clusters. Les résultats indiquent une réduction de l'espace des scénarios de l'ordre de 98% à 99%. Par exemple, pour le cas de 8 pannes, sans outil de compression, 12870 scénarios différents doivent être traités et leurs solutions de mapping/routage sauvegardés. En appliquant la technique présentée, seulement 153 scénarios doivent être sauvegardés, les solutions pour les autres cas étant obtenus par les opérations de symétrie décrites. Ces résultats représentent tout autant un gain de stockage qu'un gain de temps de traitement. En effet, en supposant par exemple que le traitement (mapping/routage) nécessite un temps de l'ordre de 10 secondes par scénario de pannes, alors le traitement sans technique de compression de toute la gamme de 8 pannes nécessite plus de 35 heures, contre moins de 21 minutes en utilisant le procédé présentement décrit. De plus, en suivant une approche itérative, à la moindre modification, il convient de refaire tout le processus. Le gain de temps peut donc être extrêmement substantiel.

Avantageusement, l'invention trouvera application pour les solutions embarquées (présentant des ressources de calcul et de mémoire limitées).

Avantageusement, la symétrie peut être utilisée pour réduire le nombre d'architectures à traiter afin de garantir le déploiement d'une application sur une gamme de processeurs qui offrent la même capacité de calcul mais dont les architectures sont différentes.

Avantageusement, l'invention peut aussi servir pour de la reconfiguration "en-ligne" lorsqu'une panne survient durant l'exécution et qu'il est besoin d'une nouvelle solution de mapping/routage afin de reconfigurer la puce et de continuer l'exécution de l'application.

Avantageusement, l'invention peut servir pour de la reconfiguration "en-ligne" à titre préventif, par exemple dans le but de préserver la durée de vie d'une puce. Ainsi, lorsque la température d'une zone de la puce atteint un certain seuil, certaines ressources de calcul peuvent être désactivées dans cette zone et sont remplacées par d'autres ressources issues d'une autre zone où la température est moins élevée, ce qui peut imposer ou déclencher une reconfiguration (*Dynamic Thermal Management*).

Avantageusement, la méthode peut être utilisée pour évaluer la résistance aux pannes de certaines structures NoC. En particulier, dans le cadre de développement de nouvelles architectures manycore, pourront être sélectionnées des processeurs dont l'architecture permet un taux de compression élevé des espaces des scénarios de pannes.

Avantageusement, les méthodes divulguées pourront trouver application pour le mapping des portes (LUT) et le routage des communications dans les solutions *Field-Programmable Gate Array FPGA* que ce soit dans un but de simulation ou d'implémentation. En utilisant la ou les symétries qui caractérisent les FPGA, des techniques de mapping/routage (à base de graphes) peuvent être accélérées en détectant les solutions équivalentes, réduisant ainsi l'espace de recherche (*Symmetry Breaking*).

Avantageusement, il pourra être procédé à un partitionnement homogène du *hardware*, dans le but de créer des niveaux hiérarchiques. L'utilisation de la symétrie permet d'identifier des blocks équivalents qui s'apparentent alors à un niveau hiérarchique. Plusieurs niveaux, imbriqués ou pas, peuvent être construits et peuvent servir par la suite à développer et à optimiser des outils de partitionnement ou de placement ou de routage hiérarchiques (par "étage").

Il est divulgué un procédé implémenté par ordinateur pour la compression de l'ensemble des scénarios de pannes d'un processeur comprenant des unités de calcul interconnectées par un réseau de communication présentant des symétries de topologie, chaque scénario de panne correspondant au nombre et à l'emplacement d'une ou plusieurs unités de calcul *défaillantes* et le procédé comprenant les étapes de réception ou détermination d'une ou plusieurs symétries de topologie; de détermination des scénarios équivalents au moyen desdites symétries de topologie; chacune des classes d'équivalence de pannes étant associée à une solution d'allocation de ressources déterminant un placement spécifique des tâches des applications sur les unités de calcul et un routage spécifique des échanges de données sur le réseau de communication.

L'invention manipule une ou plusieurs "symétries de topologie". Une "symétrie de topologie" peut également être dénommée "symétrie topologique" (en anglais "*symmetry in topology*" or "*symmetry of the topology*" ou *"topology symmetries*" ou *"topological symmetry*")*.* La notion de topologie peut, par exemple et dans certains cas, renvoyer au graphe de la topologie. L'expression "symétrie de topologie" ou "symétries topologiques" est à prendre dans son acceptation la plus large. En particulier, une symétrie topologique n'est pas réductible à de seules symétries de géométrie. Une symétrie topologique peut être logique et/ou physique: i.e. "logique" ou "physique" ou "logique et physique". L'arrangement physique, c'est-à-dire la configuration spatiale du réseau est appelé topologie physique. La topologie logique représente la façon dont les données transitent dans les lignes de communication. Les symétries selon l'invention peuvent correspondre à des géométries "logiques" ou "fonctionnelles" ou "architecturales", c'est-à-dire opérant à un niveau d'abstraction plus élevé que le seul agencement physique des composants sur le circuit du processeur, lesquels peuvent ne pas présenter de symétries géométriques à proprement parler (les symétries physiques ne sont toutefois pas exclues si elles trouvent leurs contreparties dans des symétries logiques ou fonctionnelles). Par exemple, un processeur avec des circuits, "cores" ou unités de calcul inégalement réparties dans l'espace peut néanmoins être vu fonctionnellement comme un ensemble d'unités de calcul ou clusters présentant des symétries exploitables par l'invention. En d'autres termes, les symétries selon l'invention relèvent d'une approche topologique (ou d'architecture).

Avantageusement, mais optionnellement, la topologie du réseau de communication est choisie dans la liste comprenant: *Bus, Point to Point, Daisy chain, Crossbar, Ring, Star, Tree, Fat Tree, Hypertree, Clos, Y, Delta, Omega, Hypercube, Folded Cube, Fibonacci Cube, Cube-connected cycles,* ainsi que leurs extensions ; *Grid, 2D Mesh, 3D Mesh 3D Multi-mesh* et les dimensions supérieures, ainsi que leurs extensions ; *2D Torus, 3D Torus,* et les dimensions supérieures ainsi que leurs extensions ; hybride des topologies précédentes ; *Fully connected* (i.e. complète ou *Full Mesh*).

Concernant les symétries de topologies (ou symétries topologiques), une approche par modélisation graphique est possible. La topologie physique et/ou logique d'une plateforme de calcul (e.g. processeur multi-coeur, multiprocesseur, serveur de calcul, ...) peut en effet être modélisée par un graphe G(V,E) (orienté ou pas, pondéré ou pas, étiquetés ou non étiquetés, etc) où l'ensemble des noeuds V modélise les unités de calcul de la plateforme, et l'ensemble des arcs et/ou arêtes E modélise les liens d'interconnexion entre ces unités. Chaque noeud v de V peut être caractérisé par son architecture, sa puissance de calcul, son nombre d'unités de calcul élémentaire, ses mémoires et leur taille, le nombre des registres, etc (liste non exhaustive). Deux noeuds sont dits identiques sur la base d'une liste prédéfinie de caractéristiques si et seulement s'ils sont identiques sur chacune de ces caractéristiques. Un lien d'interconnexion e de E est défini par ses extrémités, exemple e=(v1,v2) (arc si orienté ou arête si non orienté), et il est caractérisé par sa capacité, taille de ses mémoires tampons (buffers), sa bande passante, largeur de son bus (en bits), etc (liste non exhaustive). De même, deux liens sont dits identiques (sur le fondement d'une liste prédéfinie de caractéristiques) si et seulement s'ils sont identiques sur chacune de ces caractéristiques.

Les techniques d'analyses de graphes sont utilisables pour détecter et/ou analyser et/ou déterminer et/ou gérer les symétries. Un isomorphisme de graphe désigne une bijection de noeuds qui préserve l'adjacence et la non-adjacence des noeuds ainsi que les degrés des arêtes. On dit que cette bijection préserve la structure du graphe. Dans le cas où un isomorphisme est défini du graphe vers lui-même, il est appelé « automorphisme de graphe» (ce qui est le cas présent, l'isomorphisme de graphe est du graphe représentant la topologie physique et/ou logique vers lui-même). Les automorphismes définissent des permutations avec les caractéristiques qui sont celles des isomorphismes. Autrement dit, c'est une bijection de l'ensemble de sommets du graphe vers lui-même qui préserve l'ensemble des arêtes.

Les symétries géométriques peuvent être optionnellement utilisées pour représenter graphiquement un automorphisme. Cependant, ceci est généralement dépendant du dessin représentant le graphe de la topologie. De plus, certains automorphismes de graphes ne peuvent être visualisés graphiquement par une opération de symétrie géométrique. Dans le cas présent, les automorphismes de graphes en général sont considérés: en aucun cas il n'y a de limitations aux seules symétries géométriques. Les symétries sont de nature topologique.

Une opération de symétrie peut être définie ou interprétée dans le sens d'un automorphisme du graphe G modélisant la topologie physique et/ou logique de l'architecture (i.e. la plateforme de calcul), que le graphe soit orienté ou non-orienté, pondéré ou non-pondéré, étiquetés ou non étiquetés (Voir lexique de la théorie de graphe). Le graphe obtenu après une opération de symétrie (automorphisme) ne diffère du graphe initial que par les labels des noeuds et des arrêtes. Leurs structures sont complètement équivalentes. Une simple relabellisation permet de retrouver le graphe initial.

Les opérations de symétrie transforment ou associent un scénario de pannes en un autre scénario de pannes équivalent (en forme et en fonctionnalité). En d'autres termes, des classes peuvent être déterminées comme équivalentes à la suite de l'application d'une séquence d'opérations de symétrie suivie d'une relabellisation (par exemple). Il est procédé à l'exploration de l'ensemble des scénarios de manière à obtenir des classes d'équivalence de pannes. Les scénarios équivalents forment une classe d'équivalence et chaque classe d'équivalence est associée à une solution d'allocation de ressources.

Les symétries (et /ou opérations de symétrie) peuvent être "reçues" (par exemple depuis un module logiciel externe ou depuis une personne concepteur de circuits) ou "déterminées" par des moyens d'analyse et de calcul. La détection des symétries d'une topologie revient à constituer l'ensemble des automorphismes du graphe G modélisant la topologie ("Graph automorphism problem"). En sus de la détection des symétries par l'utilisateur ou le développeur, un certain nombre de techniques peuvent permettre de réaliser l'analyse de la topologie physique et/ou logique, et ce de manière automatique. Ces techniques incluent l'emploi (éventuellement combinatoire) d'arbres de recherche des permutations qui répondent aux exigences d'isomorphisme de graphes. Des outils efficaces existent pour résoudre ce problème (Nauty, Saucy et Bliss). Il est rappelé que la composition d'automorphismes est un automorphisme. De même, la composition d'opérations de symétrie est une opération de symétrie. De plus, à toute opération symétrie, on peut associer une opération inverse qui est alors aussi une opération de symétrie.

Une opération de symétrie désigne une transformation qui comprend (liste non exhaustive, les éléments indiqués étant combinables entre eux): des déplacements (conservant les distances et les angles orientés), des isométries (conservant les distances et les angles), les similitudes (conservant les rapports de distance), des transformations affines (conservant les parallélismes), des transformations homographiques (conservant les droites), et des inversions par exemple (conservant l'ensemble des droites et des cercles dans le cas plan). Une transformation peut aussi comprendre une ou plusieurs transformations bidifférentiables (ou difféomorphismes), des transformations conformes ou anticonformes (conservant les angles), des transformations équivalentes ou équiaréales (conservant les aires dans le cas plan), des transformations bicontinues ou homéomorphismes (conservant les voisinages des points), des déplacements (réflexions, des symétries centrales, des translations, des rotations), des homothéties, des affinités, etc.

Dans un développement, chacune des classes d'équivalence (regroupant des scénarios équivalents) est associée à une solution d'allocation de ressources de calcul. Dans un développement, *une ou plusieurs classes* d'équivalence est associée à *une ou plusieurs solutions* d'allocation de ressources de calcul. En d'autres termes, les schémas (une classe, une solution), (une classe, plusieurs solutions), (plusieurs classes, une solution) et (plusieurs classes, plusieurs solutions) sont possibles.

Dans un développement, la détermination des scénarios équivalents est effectuée par application d'un moteur d'inférences. Le moteur d'inférences peut être à base d'opérations de symétrie ou bien encore utiliser des outils permettant de résoudre des isomorphismes de graphes (déterminer que deux graphes finis sont isomorphes i.e. bijection entre les sommets qui préserve les arêtes). Divers outils logiciels de détection de symétrie peuvent être utilisés.

Dans un développement, la détermination des scénarios équivalents comprend l'association d'un ensemble d'identifiants à chaque scénario de panne. A chaque scénario est associé un ensemble d'identifiants, chacun de ces identifiants correspondant à un ordre d'énoncé des pannes du scénario. Il se peut que deux énoncés différents résultent en un même identifiant. Dans ce cas, il n'est renseigné qu'une seule et unique fois. Les identifiants possèdent plusieurs propriétés. Deux scénarios équivalents ont le même ensemble d'identifiants. Si un identifiant est commun aux ensembles d'identifiants de deux scénarios différents, alors ces scénarios sont équivalents. Alors, pour prouver l'équivalence de deux scénarios, il suffit de trouver un identifiant commun aux deux.

Pour ce faire, une manière de procéder consiste à a) choisir un scénario dans l'ensemble des scénarios non encore testés, de tester l'équivalence en calculant un de ses identifiants et en vérifiant son appartenance aux ensembles d'identifiants des classes d'équivalence déjà identifiées. Si à l'étape b) la comparaison montre que l'identifiant du scénario testé appartient à un de ces ensembles, alors le scénario est indiqué comme étant testé, on saute l'étape suivante c) et on procède directement à l'étape d). Sinon, à l'étape c) une nouvelle classe est créée, classe d'équivalence dont le scénario testé devient le "représentant". L'ensemble de ses identifiants est alors calculé et ces identifiants sont sauvegardés pour de prochains tests. A l'étape d), si l'ensemble des scénarios de pannes non testés encore n'est pas vide, il est procédé de nouveau à l'étape a) (procédé récursif). Sinon, l'algorithme se termine car l'ensemble des scénarios aura été parcouru (et l'ensemble des classes d'équivalence et de leurs identifiants auront été déterminés).

Dans un développement, la détermination des scénarios équivalents comprend l'association d'un identifiant unique à chaque scénario de panne. Afin d'éviter de sauvegarder les ensembles d'identifiants et d'accélérer l'identification des scénarios équivalents, il est possible d'utiliser des identifiants qui présentent la caractéristique d'avoir une relation d'ordre total. Les identifiants peuvent être alors ordonnés et il devient alors possible de calculer le minimum (resp. le maximum) d'un ensemble d'identifiants selon cette relation d'ordre. Ce minimum (resp. maximum) est le même pour des scénarios équivalents. La technique précédemment décrite est reprise mais cette fois-ci en n'utilisant (calculant, comparant et sauvegardant) que le minimum (resp. maximum) des identifiants d'un scénario et de sa classe d'équivalence. Ce minimum (resp. maximum) sera avantageusement calculé par l'emploi d'une labellisation alphabétique/alphanumérique et de techniques de concaténation de caractères, ce développement sera détaillé ci-après.

Dans un développement, l'identifiant unique est obtenu par concaténation des chaînes de caractères formant lesdits identifiants. Les chaînes de caractères peuvent être numériques (e.g. 5125255) ou alphabétiques (e.g. abhdgjkie) et/ou alphanumériques (54sde454h). Les entiers (toutes bases incluses : binaire, décimale, octale, hexadécimale, etc.) et les chaines de caractères présentent cet aspect d'existence d'une relation d'ordre total, mais une relation d'ordre peut être définie exhaustivement sur n'importe quel ensemble. Par exemple il est possible d'établir une relation d'ordre total R sur l'ensemble {0,1,a,b,bx} selon laquelle bx>0>a>1>b. Il suffit juste qu'une relation soit totale, en d'autres termes capable d'ordonner l'ensemble des mots possibles qu'il est possible de composer à partir d'un alphabet (au sens mathématique et pas seulement alphanumérique) donné. La technique de concaténation proposée est efficace et rapide.

Dans un développement, les symétries comprennent une ou plusieurs rotations axiales autour d'un axe comprenant une ou plusieurs unités de calcul, selon des angles -90°/+90/+180° et un ou plusieurs déplacements ou décalages verticaux ou horizontaux. Un décalage est encore appelé "shift" en anglais.

Dans un développement, les scénarios de pannes équivalents sont déterminés par exploration combinatoire, ladite exploration combinatoire comprenant la construction d'un ou plusieurs arbres de classes d'équivalences.

Dans un développement, le procédé comprend en outre la création d'un fichier spécifiant l'allocation de ressources.

Dans un développement, le procédé comprend en outre la détermination d'un taux de compression de l'espace des scénarios de pannes, le taux de compression étant associé au type d'architecture du processeur.

Dans un développement, le procédé pour la décompression de l'ensemble des scénarios de pannes d'un processeur, après le démarrage du processeur, comprend la détermination d'une ou plusieurs pannes associées à une ou plusieurs unités de calcul au démarrage du processeur; la caractérisation du scénario de pannes correspondant; l'identification de la classe d'équivalence de pannes et de la solution d'allocation de ressources de calcul associée à ladite classe d'équivalence de pannes.

Dans un développement, le procédé comprend en outre la reconfiguration du processeur démarré, la reconfiguration comprenant l'application au processeur de la solution d'allocation de ressources de calcul.

Une "reconfiguration" désigne une opération qui consiste à replacer des tâches sur de nouvelles ressources de calcul autres que celles qui leurs ont été attribuées initialement. Ceci implique aussi de recalculer de nouveaux chemins de routage qui résultent du replacement de ces tâches.

Dans un développement, la reconfiguration s'effectue au moment de, ou après, la survenue d'une ou plusieurs pannes d'une ou plusieurs unités de calcul du processeur afin de continuer l'exécution de l'application sur le processeur.

Dans un développement, la reconfiguration s'effectue avant la survenue d'une panne d'une ou plusieurs pannes d'une ou plusieurs unités de calcul du processeur de manière préventive, une ou plusieurs pannes étant simulée ou anticipée. En particulier, une ou plusieurs reconfigurations peuvent être effectuées de manière préventive, afin par exemple de préserver la durée de vie d'un processeur. Cette technique peut se combiner avec de la "gestion dynamique des températures" (DHM) des unités de calcul du processeur.

Dans un développement, le procédé comprend le classement du processeur dans une gamme regroupant des processeurs dont le nombre d'unités de calcul défaillantes est identique. Une gamme regroupe l'ensemble des architectures dont la topologie répond à certains critères prédéfinis. Ces critères sont généralement globaux (capacité de calcul globale, bande passante globale, ...) auxquels peuvent s'ajouter des critères plus spécifiques (e.g. architecture comprenant x unités de calcul de capacité C, x' unités de calcul de capacité C' ainsi que y liens de débit D, y' liens de débit D', etc). Les automorphismes de graphes définissent des relations d'équivalence de graphes. Dans le cas présent, les automorphismes de graphes (i.e. symétrie) permettent de définir des classes d'équivalence de topologies qui partitionnent l'ensemble des topologies d'une gamme. Chaque partition rassemble des graphes de topologies qui sont équivalents selon les caractéristiques prédéfinies à un automorphisme près.

Dans un développement, une unité de calcul défaillante est associée à un taux de défaillance ou de confiance d'exécution, ladite défaillance étant totale ou partielle. Selon un mode de réalisation spécifique sont manipulées des unités de calcul dans un état binaire: ces unités de calcul sont fonctionnelles ou elles ne le sont pas. La gestion des pannes telle que décrite garantit une meilleure certitude d'exécution sur des coeurs sains. Néanmoins, selon d'autres modes de réalisation, en complément de la mise en oeuvre précédente ou comme substitution, une approche probabiliste ou en "strates" peut également être poursuivie. Par exemple, une unité de calcul peut être associée à un "taux de confiance d'exécution". Une unité saine aura alors et par exemple un taux de confiance de 100%, mais une unité de calcul dont la mémoire est partiellement hors service (ou présentant d'autres problèmes) pourra être associée avec un taux de confiance de 80% (par exemple). Avec ce type de mécanisme, il est possible d'obtenir à une segmentation plus riche et fine en matière d'allocation des ressources de calcul (et de "gammes" de processeurs, cad aux propriétés plus précisément différenciées). Il est souligné que ce type de solutions est parfaitement combinable (e.g. complémentaire) avec les approches dites "spare" ou d'autres mécanismes visant à assurer une robustesse aux pannes des processeurs.

Dans un développement, le procédé comprend en outre l'identification d'un ou de plusieurs liens symétriques à partir de la détermination ou de la réception d'une ou plusieurs symétries de topologie. Les liens symétriques désignent les liens d'interconnexion, i.e. les liens de communication entre les unités de calcul. Une fois reçues ou calculées les symétries de la topologie du réseau, un ensemble de liens symétriques peuvent être déterminés. Par suite, après labellisation, ces liens symétriques peuvent être manipulés, pour par exemple déterminer les classes d'équivalence.

Il est divulgué un produit programme d'ordinateur, ledit programme d'ordinateur comprenant des instructions de code permettant d'effectuer l'une quelconque des étapes du procédé lorsque ledit programme est exécuté sur un ordinateur.

Il est divulgué un système pour la compression ou la décompression de l'espace des scénarios de pannes d'un processeur, le système comprenant des moyens pour mettre en oeuvre l'une quelconque des étapes du procédé.

### Description des figures

Différents aspects et avantages de l'invention vont apparaitre en appui de la description d'un mode préféré d'implémentation de l'invention mais non limitatif, avec référence aux figures ci-dessous :
La figure 1 illustre schématiquement un processeur *many-core* à 9 clusters;
La figure 2 illustre un exemple de relabellisation après une opération de symétrie;
La figure 3 illustre la mise en correspondance entre une solution de placement/routage d'un scénario de pannes et un scénario de pannes équivalent;
La figure 4 illustre deux exemples de scénarios à trois pannes;
Les figures 5A et 5B illustrent la notion de distance symétrique;
La figure 6 illustre l'équivalence de deux exemples de scénarios et le calcul d'identifiants;
Les figures 7A, 7B et 7C illustrent différents aspects du procédé.

### Description détaillée de l'invention

Un microprocesseur "multi-coeur" (*multicore* en anglais) est un processeur possédant plusieurs coeurs physiques qui travaillent en parallèle. Un coeur physique est un ensemble de circuits capable d'exécuter des programmes de façon autonome. Toutes les fonctionnalités nécessaires à l'exécution d'un programme sont présentes dans ces coeurs: compteur ordinal, registres, unités de calcul, etc. Le terme "multi-coeur" est en général employé pour décrire un processeur composé d'au moins deux coeurs (ou unités de calcul) gravés au sein de la même puce. Ces unités de calcul peuvent être clustérisées (ou pas). Les unités de calcul sont interconnectées par un réseau de communication (Network on Chip ou NoC).

Les récentes avancées technologiques en conception et création de circuits permettent maintenant la production de processeurs contenant un grand nombre de coeurs génériques (de quelques dizaines à plusieurs centaines) avec des hiérarchies mémoires complexes: on ne parle alors plus de "*multicore*" mais de systèmes "*manycore*"*.*

Un certain nombre de problèmes sont dus à l'augmentation du nombre de coeurs. Par exemple, cette augmentation amène à une situation où les interconnexions deviennent le goulot d'étranglement de la quête de performances. Aux différentes contraintes d'exécution viennent ainsi s'ajouter des techniques de programmation parallèle particulières pour exploiter tout le potentiel du circuit (développement de couche de runtime, analyse de performance, contrôle distribué, compilation, gestion des communications sur un réseau sur puce, etc).

L'exploitation - et donc la commercialisation d'une puce dégradée - peut être obtenue par différents moyens et/ou méthodes.

Une première approche consiste à réaliser une allocation (placement et routage, *routing* et *mapping* en anglais) d'une application (logicielle) sur les ressources de calcul et de communication d'un processeur manycore dégradé. Généralement, ces opérations se font de manière statique et "hors-ligne" (c'est-à-dire quand la puce n'est pas sous tension). Ces techniques supposent aussi une connaissance totale et entière de l'architecture des processeurs sur lesquelles l'application logicielle va être déployée. Par exemple, une approche pour permettre de vendre ces processeurs dégradés peut consister à définir des gammes de puissances de calcul. Une gamme donnée rassemble alors tous les processeurs qui garantissent la disponibilité d'un minimum global fixé de ressources de calcul. Ainsi, en suivant cette stratégie de commercialisation et à cause de l'absence de différenciation selon l'emplacement des ressources saines, des processeurs correspondant à différentes architectures peuvent se retrouver au sein d'une même gamme. Par exemple, dans l'exemple d'un manycore dont l'architecture prévoit 16 clusters de calcul dont la gamme de processeurs dégradés issus de ce manycore comprend seulement 15 clusters fonctionnels (un unique cluster étant en panne), il existe alors 16 architectures possibles dans cette gamme. Chaque architecture correspond au cas d'un des 16 clusters en état de défaillance. Il se pose alors le problème du déploiement d'une même application sur des processeurs manycore dont la capacité globale de calcul est la même, mais dont l'architecture diffère d'une processeur à l'autre. En effet, l'information n'est connue que très tardivement, à l'allumage du processeur. Par suite, cette technique de placement/routage est limitée.

Il est possible de prévoir une solution permettant de "reconfigurer" le déploiement de l'application sur la puce selon le scénario de pannes de cette dernière. En l'absence d'une telle solution, les processeurs dégradés ne peuvent pas être pleinement exploités et ne peuvent pas être commercialisés en l'état. La plupart des processeurs multi/many-cores actuels utilisent des bus partagé (par exemple le many-core ClearSpeed CSX) ou certains types de NoCs de type RING. Ces circuits tendent à supprimer le problème de la reconfiguration en en éliminant l'explosion combinatoire des scénarios de pannes possibles. De fait la littérature brevet ne mentionne aujourd'hui pas même ce problème technique (et a fortiori ne propose pas de solution technique). Cependant, ces circuits à bus partagé ou NoCs de type RING ne sont pas extensibles (*scalable*) et les prochaines générations de processeurs *manycore* vont vraisemblablement devoir s'affranchir de ce types de circuits pour adopter des NoCs de type "Tore 2D", "Tore 3D" ou autres pour lesquels ce problème technique se posera de façon aigüe.

Une autre approche possible consiste à modifier le hardware, par exemple avec l'implémentation de routeurs spéciaux. Cette solution peut être complémentaire des exemples divulgués présentement.

Concernant l'exploration de l'espace des architectures pour résoudre le problème de déploiement, une première solution consiste à explorer entièrement l'espace des architectures d'une gamme et réitérer les algorithmes de placement/routage pour chaque architecture (scénario de pannes) et sauvegarder les solutions obtenues. Lors du démarrage d'une puce, il est ensuite possible de détecter quelle est son architecture et d'utiliser la solution correspondante. Par construction, cette technique est exacte (i.e. optimale) et apporte la garantie, à la phase de compilation, de la possibilité (ou non) de déployer l'application quelque soit le scénario de pannes au sein d'une gamme. Cependant, cette technique est généralement coûteuse en temps d'exécution car le nombre de configurations à explorer est très grand. Un problème de stockage des solutions se pose aussi à cause de la taille volumineuse du binaire qui en résulte. En effet, chaque scénario de panne nécessitant son propre binaire; la taille du binaire final pourrait être très grande si on devait stocker toutes les reconfigurations pour la gamme spécifiée.

Par contraste aux techniques précédemment abordées, certains modes de réalisation de l'invention permettent de traiter avantageusement les pannes en matière de ressources de calcul. Certains modes de réalisation de l'invention considèrent en effet des processeurs avec un NoC entièrement fonctionnel, c'est-à-dire sans panne de routeurs (ou de liens). Les liens de communications ainsi que les routeurs sont généralement moins sujets aux pannes.

Il est souligné que les techniques divulguées ci-après s'appliquent au placement et au routage (les deux). Afin d'éviter des notations supplémentaires qui compliqueraient la description, il sera fait mention par la suite du placement uniquement, mais la divulgation s'appliquera de la même manière au routage (liens de routage).

Le terme "allocation de ressources" consiste d'opérations de placement et de routage permettant d'allouer les ressources de calcul et de communication nécessaires pour exécuter et faire communiquer les différentes tâches d'une application.

Le terme "placement" désigne donc l'opération qui assigne chacune des tâches d'une application à des supports d'exécution (i.e. unités de calcul e.g. core, processeur, cluster, serveur, etc), lesquels implicitement supposent des moyens de mémoire. Les tâches assignées à un ou plusieurs supports seront alors exécutées uniquement par ceux-ci. L'ordonnancement (ou "scheduling" en anglais) au niveau d'un support déterminera l'ordre et les durées pendant lesquelles les tâches accèdent à ces ressources partagées (qui leurs sont allouées).

Le terme "routage" désigne l'opération qui calcule un chemin composé de liens de communication qui relient les unités de calculs (Bus, NoC, réseau local, internet,...) afin d'assurer le transfert de données entre des tâches qui communiquent entre elles et qui s'exécutent sur des supports différents.

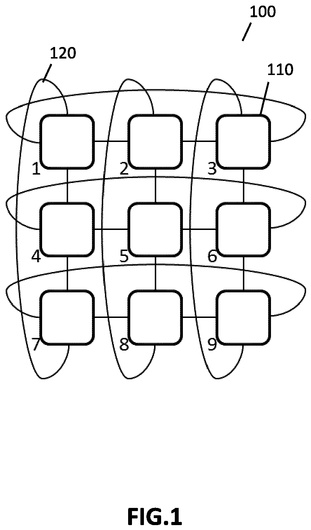

La figure 1 illustre schématiquement un processeur *manycore* 100 à 9 clusters 110 (ou *"cores"* / "coeurs" ou "unités de calcul") de type Tore 2D 3x3. Les clusters sont numérotés de 1 à 9 et sont interconnectés par un NoC ou des interconnexions 120 (représenté par les lignes sur la figure). La plupart des processeurs *many-core* comportent des symétries. Ces symétries permettent de définir des opérations qui transforment l'architecture initiale en une autre qui lui est totalement identique (l'architecture est dite "équivalente") en termes de forme et de fonctionnalités. De par l'architecture de son NoC, un processeur *manycore* homogène Tore 2D comporte plusieurs symétries. Certaines symétries sont partagées avec l'architecture Mesh sous-jacente (Damier). Sur l'exemple de la figure 1, on dénombre par exemple: des rotations axiales dans le plan du Mesh (par rapport à une droite qui le traverse perpendiculairement au niveau du cluster 5, de -90°/+90/+180°); une rotation de 180° dans l'espace autour d'un axe qui traverse les clusters 2, 5 et 8; une autre rotation de 180° dans l'espace autour d'un axe qui traverse les clusters 4, 5 et 6; une rotation de 180° dans l'espace autour d'un axe qui traverse les clusters 1, 5 et 9; une rotation de 180° dans l'espace autour d'un axe qui traverse les clusters 3, 5 et 7. Les liens sur les bords du Tore 2D donnent lieu à des symétries supplémentaires : un déplacement ou décalage (shift) vertical des lignes de clusters d'un pas vers le haut ou vers le bas; et un déplacement ou décalage (shift) horizontal des colonnes de clusters d'un pas vers la gauche ou vers la droite. Ces deux dernières symétries justifient parfois l'adoption d'une architecture Tore 2D plutôt qu'une architecture Mesh asymétrique sur les bords (placement et routage en sont très dépendants).

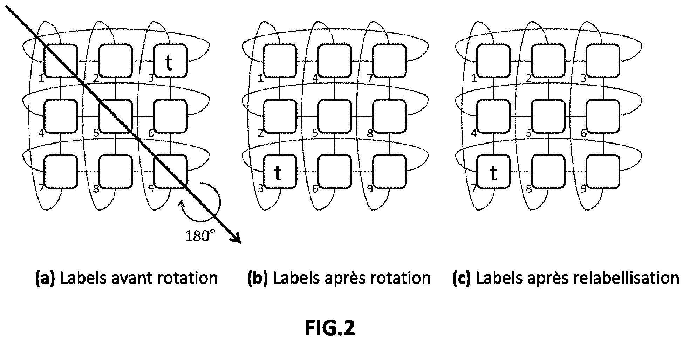

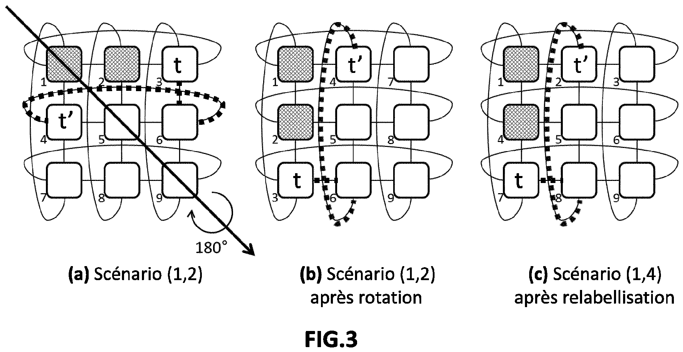

Les figures 2A, 2B et 2C illustrent la labellisation avant et après une opération de symétrie. La figure 2A montre les labels avant la symétrie (de rotation). La figure 2B montre les labels après la rotation. La figure 3B montre les labels après relabellisation.

A chaque opération de symétrie est associée une fonction de relabellisation qui permet de retrouver l'ordre initial des labels de l'architecture. Par exemple, à la rotation de 180° dans l'espace autour de l'axe qui traverse les clusters 1, 5 et 9 correspond la fonction de relabellisation de clusters [1,4,7,2,5,8,3,6,9] -> [1,2,3,4,5,6,7,8,9]. Il en est de même pour les liens d'interconnexion dont les labels ne sont pas mentionnés ou représentés dans un souci de simplification.

Un scénario de pannes est défini par le nombre et l'emplacement des unités de calcul (i.e. des clusters dans l'exemple présent) qui sont défectueuses. Par exemple dans un scénario à trois pannes, on notera un scénario (i,j,k) un scénario pour lequel seuls les trois clusters i,j et k sont en panne. L'ordre d'énoncé de ces pannes n'est pas important, i.e. les scénarios (i,j,k), (i,k,j), (j,i,k), (j,k,i), (k,i,j) ou (k,j,i) sont les mêmes.

Les figures 3A, 3B et 3C permettent de montrer comment la symétrie peut être utilisée pour compresser l'espace des scénarios de pannes. La figure 3A illustre un exemple simplifié d'un scénario à deux pannes (1,2). La figure 3B montre le scénario (1,2) après rotation. La figure 3C montre la relabellisation après la rotation.

En appliquant une opération de symétrie (Figure 3B) suivie d'une relabellisation (Figure 3C), il est illustré que les deux scénarios (1,2) et (1,4) sont les deux facettes d'une même situation (qui est celle de deux clusters adjacents en panne). En combinant encore plus d'opérations de symétrie comme le décalage horizontal et vertical, des conclusions similaires peuvent être tirées pour des scénarios comme (2,3), (1,3), (1,7), (3,6), (3,9), etc. Tous ces scénarios sont équivalents au scénario (1,2) et forment ce qu'on peut appeler une "classe d'équivalence" de scénarios de pannes. Une classe d'équivalence contient exclusivement des scénarios qui peuvent être tous ramenés, par des séquences d'opérations de symétrie, à un même et unique scénario de pannes (qui leur est donc équivalent). Celui-ci est ainsi désigné comme le représentant de la classe d'équivalence. Etant donnée la propriété de transitivité d'une relation d'équivalence, n'importe quel scénario peut être désigné comme représentant de la classe à laquelle il appartient. Dans l'exemple présent, le scénario peut être choisi et la classe d'équivalence peut alors être désignée par la classe (1,2).

Définir des classes d'équivalence présente l'avantage de n'avoir à résoudre le problème de placement/routage et de ne sauvegarder la solution que pour le seul et unique représentant de chaque classe. En disposant de la séquence d'opérations de symétrie, pour ramener un scénario au représentant de sa classe, il est possible de d'utiliser cette même séquence pour inverser l'ordre d'application des opérations de symétrie afin de relabelliser la solution de placement/routage du représentant en une solution de qualité exactement égale pour le scénario en question. Ce scénario sera connu au démarrage de la puce.

Dans l'exemple de la figure 3, pour calculer une solution de placement/routage pour le scénario (1,4) représenté à la figure 3C à partir de la solution associée au scénario (1,2) représenté à la figure 3A, il est possible d'appliquer la fonction de relabellisation des clusters et des liens d'interconnexion associée à la rotation de 180° autour de l'axe traversant les clusters 1,5, et 9.

Dans l'exemple du scénario (1,2) représenté à la figure 3A, deux tâches de calcul t et t' sont placées respectivement sur les clusters 3 et 4 (non défaillants), et communiquent en utilisant le chemin 3->6->4 qui est composé par les liens d'interconnexion directs 3->6 et 6->4. Si on est en présence d'un scénario (1,4), i.e. une puce dégradée avec les clusters défaillants 1 et 4, *la tâche t' ne peut plus être effectuée et il convient procéder à un nouveau placement (mapping). Après ce nouveau placement ou re-mapping,* la tâche t sera placée sur le cluster 7, et la tâche t' sera placée sur le cluster 2 après une symétrie de rotation de 180° autour de cet axe traversant les clusters 1,5, et 9. La communication entre t et t' s'effectuera à travers le chemin 7->8->2. Concernant l'impact de la réduction ou compression de l'espace des scénarios par exploitation d'une symétrie (ici une rotation), la classe (1,2) contient 18 scénarios de pannes équivalents ce qui correspond à un taux de compression potentiel de 1-1/18=94.44%. Ce taux de compression s'applique tout autant au temps de calcul qu'au fichier de sauvegarde des solutions de placement/routage.

Le procédé pour la mise en pratique de cette compression est décrit ci-après.

Après l'identification des classes d'équivalence de scénarios de pannes (quand les opérations de symétrie qui sauvegardent la structure d'une architecture sont explorées et énumérées), ces mêmes classes sont exploitées afin de procéder au partitionnement de l'ensemble des scénarios de pannes. Le nombre de possibilités de partitionnement de l'espace de scénarios correspond au nombre de Bell, qui est exponentiel en la taille de l'ensemble considéré.

Pour le partitionnement, une première solution pourrait consister à implémenter un moteur d'inférences à base de règles de symétrie, implémentée par exemple au moyen de langages tels que LISP ou Prolog. En partant d'un scénario donné, le moteur d'inférence se met à la recherche d'une séquence de règles à appliquer dans le but d'établir une équivalence avec le représentant d'une classe déjà répertoriée ou de créer une nouvelle classe d'équivalence si aucune équivalence n'est établie (i.e. absence de séquence). Dans ce dernier cas, le scénario devient le représentant de la nouvelle classe. Pour implémenter un tel moteur d'inférence, il convient alors de définir a) les règles de symétrie et les opérations de relabellisation qui leur sont associées et b) la priorité (ou l'ordre ou l'occurrence) d'application de chacune de ces règles et ce à chaque étape du processus de recherche (les priorités, ordres ou occurrences pouvant varier d'une étape à l'autre du processus de recherche). Les opérations de symétrie ne sont pas dotées de bonnes caractéristiques vis-à-vis de la composition. Par exemple, elles ne sont généralement pas commutatives, i.e. pour deux opérations 01 et 02, 01 * O2 donne un résultat différent de O2 * O1. De même, elles ne sont pas idempotentes: O1*O1 =/= 01. Ces caractéristiques rendent généralement très complexe la définition d'un ordre/occurrence d'application des opérations de symétrie. Il est alors difficile de définir une stratégie de recherche qui optimise le temps d'exécution. De plus, il risque d'y avoir plusieurs exceptions à l'ordre prédéfini qui doivent être prises en compte selon l'architecture. Par ailleurs, lorsqu'on utilise la symétrie, il est tentant de s'appuyer sur de l'intuition pour établir ces paramètres mais ceci s'avèrera vite, dans bien des cas, très complexe et contre-productif pour l'identification des classes d'équivalence. Les caractéristiques des opérations de symétries posent aussi un problème de définition des conditions d'arrêt d'un moteur d'inférence. Le nombre de compositions d'opérations possibles étant très grand, lorsqu'aucune équivalence avec un cas déjà répertorié n'est trouvée, il n'est généralement pas possible de dire à quel moment il est possible d'arrêter le moteur d'inférence et de conclure à la présence d'une nouvelle classe d'équivalence. Si la condition d'arrêt est trop restrictive, la technique risque en outre de ne pas être exacte et le taux de compression maximal pourrait ne pas être atteint (une classe pourrait correspondre à plusieurs partitions, si l'équivalence entre tous ses éléments n'est pas établie). L'adaptation d'un tel procédé pour chaque architecture prendra aussi beaucoup temps et sera très complexe. Ces raisons rendent le développement d'un moteur d'inférence efficace et générique non pertinent, dans le cas général.

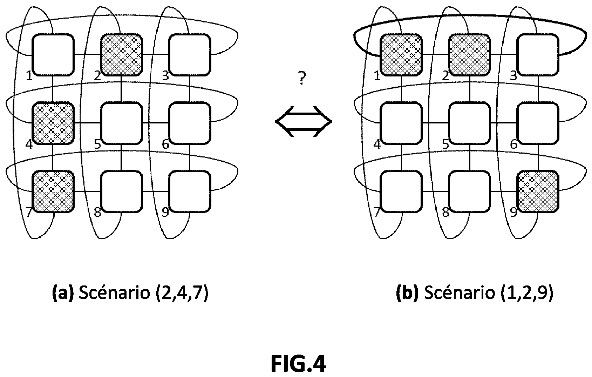

La figure 4 sert de support pour éclairer la complexité du problème technique consistant à identifier des cas équivalents. La figure 4 montre deux scénarios à trois pannes. La figure 4A montre un scénario (1,2,9) et un scénario (2,4,7). Pour montrer que ces scénarios sont équivalents, une rotation dans le plan de +90° dans le sens des aiguilles d'une montre autour du cluster central 5 change les labels des clusters adjacents 4 et 7 en 1 et 2. Le cluster 2 devient 6. Pour transformer la panne du cluster 6 en une panne du cluster 9, l'application d'un shift horizontal vers le bas sur le scénario (1,2,6) amène au scénario (4,5,9). Ensuite, en appliquant à ce dernier scénario une rotation axiale de 180° autour de l'axe qui traverse les unités 4, 5 et 6, et après labellisation, le scénario devient (4,5,3). L'application d'un shift horizontal inverse, vers le haut, et le scénario obtenu devient (1,2,9). Par l'application de cette série ou séquence de transformations, exploitant les symétries du circuit, il est possible donc d'établir l'appartenance des scénarios (1,2,9) et (2,4,7) à la même classe d'équivalence (qu'il est possible de représenter ou noter (1,2,6), en suivant par exemple un critère de minimisation de la sommes des labels).

La connaissance de l'équivalence *ex ante* permet de persévérer dans la combinatoire et la recherche de la séquence d'opérations de symétrie. Sans cette connaissance préalable, le problème de l'arrêt pourrait devenir critique. La démonstration qui vient d'être faite pour l'exemple pourrait ne pas s'arrêter, ou à défaut (i.e. si un arrêt était déclenché) aboutir à la conclusion erronée de la non-équivalence des scénarios (et donc à la conclusion de l'existence de deux classes d'équivalences). Cette première approche de recherche reste possible, mais elle est limitée.

Un autre mode de réalisation de la compression de l'espace des scénarios est décrit ci-après. Ce procédé est rapide et générique. Selon ce mode de réalisation, chaque scénario est associé avec un identifiant, de manière que deux scénarios associés à un même identifiant sont nécessairement ou forcément équivalents et sont donc interchangeables. Selon un mode de réalisation, l'identifiant peut être celui de la classe d'équivalence elle-même. Par construction, un tel identifiant intègre les transformations de symétrie et ne dépend pas des labels associés aux clusters défaillants. A cette fin, une distance est introduite: une distance inter-clusters qui ajoute la notion de symétrie aux distances inter-clusters usuelles. Ensuite, en se fondant sur cette nouvelle distance, des moyens et/ou étapes permettent d'identifier un scénario particulier.

Dans le détail, le procédé de compression comprend quatre étapes ou phases.

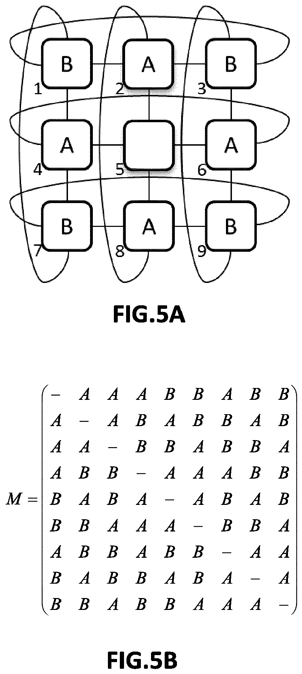

Dans une première étape est définie une distance dite "distance inter-clusters symétrique". Pour définir l'identifiant de scénario de pannes, un moyen d'identification des clusters à distance équivalente d'un autre cluster est décrit ci-après. Pour définir une distance inter-clusters, une première solution consiste à prendre en compte le nombre de liens qui séparent ces clusters (e.g. *hop count).* Cette mesure permet d'évaluer la longueur du plus court chemin de routage inter-clusters et donne ainsi une mesure pour le débit de données consommé par rapport à la capacité de routage globale du réseau. Plus celle-ci est petite, plus la congestion du réseau peut être évitée (et l'énergie économisée). La distance inter-clusters améliorée proposée ici prend en compte - en plus du hop count et la nature des liens d'interconnexion - les schémas de symétrie. Corollairement, deux couples de clusters qui sont à des *hop count* différents auront des "distances symétriques" différentes. Ces distances sont introduites en figure 5.

Les figures 5A et 5B illustrent la notion de distance symétrique. Soit une unité de calcul notée Ui. Des unités Uj et Uk sont dites à la même "distance symétrique" de Ui s'il existe une séquence d'opérations de symétrie permettant de sauvegarder l'emplacement de Ui tout en ramenant l'emplacement de Uk à celui de Uj. La Figure 5A donne un exemple pour le Tore 2D 3x3 et le cluster 5. Par des rotations de -90° / +90° / +180° dans le plan autour du cluster 5, il apparaît que les clusters 2, 4, 6 et 8 sont à la même distance symétrique du cluster 5 labélisée comme distance A. De même, les clusters 1, 3, 7 et 9 sont à la même distance symétrique du cluster 5 et sont labellisées B. Le résultat de tous les clusters peut être regroupé dans une matrice de distance symétrique M représentée à la figure 5B, *de dimension 3x3.* Mij est la distance entre Ui et Uj. Par construction, il existe autant de classes d'équivalence à deux pannes que de types de liens symétriques (i.e. de distances symétriques). Par exemple, pour la matrice M du Tore 2D 3x3, le nombre de liens symétriques est de deux (A et B). Dans ce cas, il existe deux classes d'équivalence pour les scénarios à deux pannes. Comme le nombre d'architectures possible à deux pannes est de 36 (le nombre de combinaisons de 2 parmi 9), le taux de compression est de 1 - 2/36=94.44%.

En fonction des symétries détectées et exploitées afin de définir les distances symétriques (par exemple par un développeur implémentant un logiciel de reconfiguration pour une puce donnée), différentes matrices peuvent être obtenues. Plus le nombre de symétries exploitées est grand, meilleure est la compression. Par exemple, si un développeur considère que les clusters 6 et 2 ne sont pas à la même distance symétrique de 5 du fait qu'il néglige la rotation axiale autour du centre, alors il va devoir labelliser une de ces distances autrement, C par exemple. Ceci augmentera automatiquement à 3 le nombre de classes d'équivalence pour la gamme à 2 pannes et ainsi réduira le taux de compression à 91.66%. Ce taux sera d'autant plus réduit si l'on considère que ce même développeur aurait surement négligé d'autres symétries sur les distances notées B initialement dans la matrice de l'exemple et devra alors définir des distances supplémentaires D, E et F. Dans ce cas, le taux de compression tombe à 83.33%.

Pour désigner les distances symétriques, il est possible d'utiliser des labels numériques à la place des labels alphabétiques mais ces derniers facilitent grandement le calcul et la comparaison des identifiants de scénarios permettant par la même occasion l'implémentation d'algorithmes plus génériques et plus efficaces.

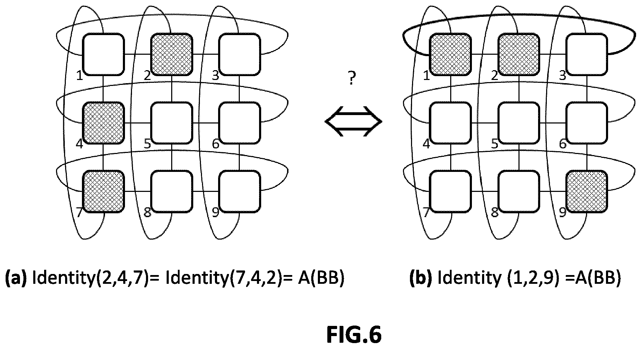

La figure 6 introduit les identifiants de scénarios et en illustre une utilisation pour établir l'équivalence des scénarios de pannes (2,4,7) et (1,2,9) fournis précédemment à la figure 4.

Dans une deuxième étape du procédé de compression, un scénario de pannes est identifié et caractérisé. Pour ce faire, les positions des pannes les unes par rapport aux autres sont utilisées, au moyen de la notion de distance symétrique définie précédemment.

Dans un mode de réalisation, l'identifiant d'un scénario (et donc de sa classe d'équivalence) est un mot pris dans un alphabet composé exclusivement des labels des distances symétriques. Pour un scénario à deux pannes (Ui,Uj), l'identifiant noté *Identity(Ui,Uj)* est donné par la distance Mij. Il est remarqué que les accolades dans l'identifiant ne sont nécessaires ni pour la définition ni pour la comparaison des identifiants. Ces accolades sont seulement représentées pour faciliter la lecture et montrer le passage d'une panne à la suivante, mais elles peuvent être supprimées lors de l'implémentation.

Pour un scénario à trois pannes (Ui,Uj,Uk), l'identifiant *Identity(Ui,Uj,Uk)* est obtenu par Mji(MkiMkj). Pour les scénarios avec un nombre de pannes supérieures, il est procédé par récurrence en utilisant un opérateur de concaténation de chaînes de caractères. En désignant par *Identity(Ui,Uj,...,Um)* l'identifiant du scénario (Ui,Uj,...,Um), alors *Identity(Ui,Uj,Uk,...,Um,Uq)* correspond à la concaténation de *Identity(Ui,Uj,...,Um)* et de (MqiMqjMqk...Mqm). La concaténation n'étant pas symétrique, l'identification dépend de l'ordre considéré dans l'énoncé des pannes du scénario. En d'autres termes, sans procédé supplémentaire, plusieurs identifiants peuvent être calculé pour un même scénario. Afin d'éviter que des scénarios équivalents ne soient pas détectés comme tel à cause de l'ordre de l'énoncé des pannes, une étape supplémentaire et optionnelle permet de s'assurer qu'ils aient un unique identifiant et assure donc l'exactitude de la technique et un taux de compression maximal. Dans un mode de réalisation, est sélectionné l'ordre d'énoncé de pannes qui donne la plus petite identification vis-à-vis de la comparaison des chaines de caractères. L'intérêt de la concaténation pour la comparaison des identifiants justifie l'emploi de labels alphabétiques. Alternativement, des caractères alphabétiques, numériques et/ou alphanumériques peuvent être utilisés. En appliquant cette technique d'identification à l'exemple de la figure 6, il est possible de montrer que les scénarios (2,4,7) et (1,2,9) sont équivalents. En effet, M47(M27M24)=A(BB) et M21 (M91 M92)=A(BB).

En conclusion, l'utilisation d'identifiants encodant les symétries permet de s'affranchir de la description d'une séquence d'opérations de symétrie afin de démontrer l'équivalence des scénarios.

Lorsque le nombre de pannes est supérieur à la moitié du nombre d'unités initialement prévu sur une puce, plutôt que de définir un scénario par ses unités en pannes, il peut être avisé de le définir par ses unités fonctionnelles pour optimiser la taille des identifiants de scénarios. La technique de calcul de l'identifiant *Identity* restera valable en rapportant les positions des unités saines par rapport à elles-mêmes. Par exemple, à partir de 5 pannes, il est plus efficace d'énumérer les 4 clusters sains restants du Tore 2D 3x3.

Dans une troisième étape du procédé de compression, l'espace des scénarios est exploré. Durant cette étape est construit un arbre de classes d'équivalence. Cette opération consiste à parcourir l'espace des scénarios de pannes possibles dans le but de le partitionner en classes d'équivalence selon la définition donnée durant l'étape précédente. Pour chaque scénario parcouru, il est procédé à la vérification de savoir s'il n'existe pas dans l'arbre un scénario répertorié qui lui est équivalent. Si ce n'est pas le cas, un nouveau noeud est ajouté à l'arbre (le scénario et son identifiant étant les représentants de la nouvelle classe d'équivalence). Les différents niveaux de l'arbre indiquent les différentes gammes. Par exemple, au sommet de l'arbre, seront trouvées les classes de la gamme d'une seule panne. Dans l'exemple du processeur de type Tore 2D 3x3, elle n'est composée que d'un seul noeud. La construction de l'arbre s'arrête lorsqu'on aura atteint le niveau maximum de pannes considérée (i.e. la gamme la plus dégradée). Cet arbre est construit une seule fois par architecture manycore car il est indépendant des applications qui y seront déployées. Le fournisseur du processeur *manycore* pourra construire et intégrer cet arbre dans les outils de développement (par exemple). Les utilisateurs ou développeurs pourront également se servir de tels arbres, par exemple lors de la conception d'applications afin de calculer et sauvegarder les solutions de placement et/ou de routage pour chacun des noeuds du niveau qui représente la gamme sur laquelle ils veulent déployer l'application.

Dans le cas de l'exploration, étant donné qu'il n'est pas possible de savoir préalablement si deux scénarios donnés sont équivalents ou pas, l'emploi d'un identifiant se révèle être particulièrement avantageux: il permet de dire que deux scénarios sont équivalents alors même que la séquence d'opérations de symétrie nécessaire pour transformer un scénario en un autre reste inconnu (non disponible, non documenté, non accessible etc).

De manière optionnelle, différentes variantes de l'explorateur peuvent être implémentées, par exemple avec le choix d'une recherche en largeur ou en profondeur, selon différents choix du représentant d'une classe d'équivalence (par exemple choisir celui dont les labels des clusters sont les plus petits).

Pour la plupart des architectures de processeurs manycore, l'espace exploré afin de construire l'arbre des classes d'équivalence peut être lui-même réduit. En effet, il n'est pas toujours nécessaire de parcourir l'espace entier. Pour l'exemple du Tore 2D 3x3, n'importe quelle panne peut être ramenée - par des opérations de symétrie - à être placée (ou relabellisée) en tant que panne du cluster 1. Afin de réduire l'espace à explorer, il est donc possible de considérer que l'unité de calcul numéro 1 est toujours en panne. Ainsi, la taille de l'espace à explorer est divisée par 9. Optionnellement, pour plus de certitude, un test peut également être implémenté afin de vérifier que l'arbre des classes d'équivalences obtenu couvre bien tous les cas de scénarios possibles.

Dans une quatrième étape du procédé de compression, une relabellisation est effectuée. Après le démarrage de la puce et la détection du scénario de panne, l'identifiant et donc la classe d'équivalence à laquelle appartient la puce peuvent être déterminés selon la technique présentée dans la seconde étape. Ainsi, on peut extraire, à partir de l'arbre des scénarios construit durant la phase 3, le scénario équivalent et la solution de placement/routage qui sont associés à la situation de panne de la puce. Il faudra alors adapter cette solution équivalente au scénario de la puce. Cette adaptation constitue l'étape ou phase de relabellisation.

Cette étape de relabellisation s'exécute sur la puce puisqu'il est besoin de connaître le scénario de la panne. Dans un contexte d'exécution embarqué, cette phase peut être optimisée en raison ou pour des ressources limitées en calcul et en mémoire (faible complexité en temps et en espace d'exécution).

Dans certains cas, l'architecture NoC peut être la même pour toutes les processeurs *manycore* (quand par hypothèse le NoC est entièrement fonctionnel ou Fault-Free). L'étape de relabellisation proposée n'est pas très consommatrice en matière de calcul. En effet, contrairement aux raisons qui invitent à relativiser l'emploi d'un moteur d'inférence, le fait de savoir au préalable que deux scénarios sont équivalents (en calculant leur identifiant et donc l'ordre d'énoncé des pannes) rend possible la détermination d'une séquence d'opérations de symétrie qui est à la fois générique et efficace pour ramener un scénario à un autre qui lui est équivalent. Par exemple, pour un Tore 2D 4x4, l'algorithme nécessite moins de 3 instructions pour détecter la séquence et ainsi relabelliser un scénario vers son équivalent. Pour cela, à partir du moment où est connue la première panne selon l'ordre qui a été obtenu pour le calcul de l'identifiant, il suffit de ramener cette panne à la panne 1 en effectuant les shifts vertical et horizontal nécessaires. Ensuite, la rotation axiale (si besoin est) déterminera le reste des pannes. Cet algorithme est de complexité O(1), c'est-à-dire la plus faible qui soit.

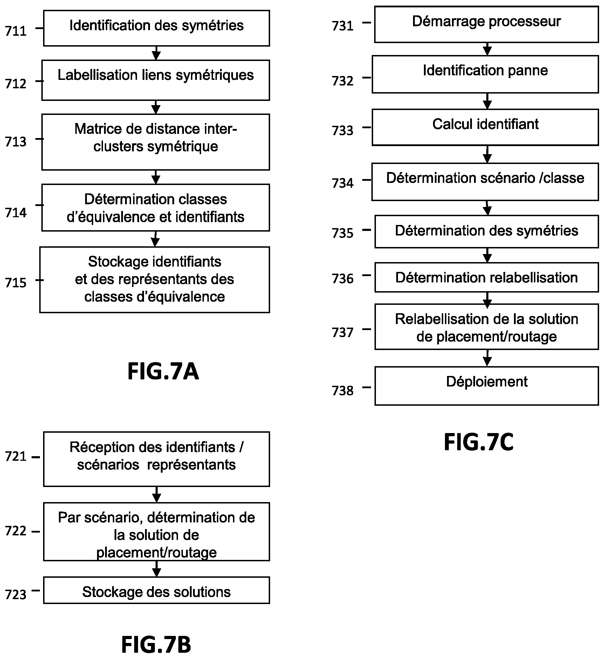

Les figures 7A, 7B et 7C illustrent différents aspects du procédé. La figure 7A illustre des exemples d'opérations généralement réalisées offline (processeur éteint). Généralement, ces opérations ne dépendent pas des applications logicielles "mappées" sur le dit processeur. Les symétries sont identifiées à l'étape 711. Les liens symétriques sont labélisés à l'étape 712. La matrice de distance inter-clusters symétrique est construite à étape 713. Il est procédé à l'exploration des scénarios (classes d'équivalence et identifiants) à l'étape 714. Il est procédé au stockage des identifiants ainsi que des représentants des classes d'équivalence à l'étape 715.

La figure 7B illustre des exemples d'opérations généralement réalisées offline (processeur éteint), pour le déploiement d'une application logicielle par exemple. A l'étape 721, les scénarios représentants de classes et leur identifiants sont reçus ou identifiés ou calculés. A l'étape 722, pour chaque scénario représentant de classe, la solution de placement/routage appropriée est calculée. A l'étape 723, les solutions sont stockées (chaque solution peut spécifier le scénario pour laquelle elle a été calculée).

La figure 7C illustre des exemples d'opérations généralement réalisées au moment de, ou après, le démarrage de la puce (par exemple après le déploiement d'une application selon la figure 7B). Les étapes énumérées ci-après peuvent être effectuées (certaines étapes peuvent être optionnelles ou modifiables ou modifiées ou les données requises reçues de modules externes, etc). Etape 731: démarrage de la puce. Etape 732: identification du scénario de panne. Etape 733: calcul de l'identifiant de la panne. Etape 734: récupération du scénario représentant la classe portant le même identifiant que celui du scénario de panne observée sur le processeur. Etape 735: calcul d'une ou de plusieurs séquences d'opérations de symétrie permettant de ramener le scénario de panne du processeur à celui du représentant de sa classe d'équivalence. Etape 736: calcul de la relabellisation à partir de la séquence d'opérations de symétrie ayant été obtenue. Etape 737: relabellisation de la solution de placement/routage associé au représentant de la classe. Etape 738: déploiement de l'application selon la solution de placement/routage relabellisée.

L'invention trouvera avantageusement application pour le "Cloud Computing", les environnements de calcul distribués, le "Grid Computing", etc. En complément de la virtualisation d'applications (éliminant les spécificités d'exécution de code sur un parc de processeurs hétérogènes), l'invention peut en effet permettre une gestion des pannes sur un ensemble de processeurs, du fait de l'abstraction topologique qui est effectuée pour exploiter les symétries. Dans un exemple simplifié, un processeur à 800 cores peut être topologiquement équivalent à deux cents processeurs à 4 cores. Par suite, l'exploitation des symétries dans l'un et l'autre cas emportent les mêmes avantages, à savoir des reconfigurations statiques (packaging en gammes, pré-commercialisation) voire des reconfigurations dynamiques durant le runtime.

La présente invention peut s'implémenter à partir d'éléments matériel et/ou logiciel. Elle peut être disponible en tant que produit programme d'ordinateur sur un support lisible par ordinateur. Le support peut être électronique, magnétique, optique, électromagnétique ou être un support de diffusion de type infrarouge.

## Revendications

1. Procédé implémenté par ordinateur pour la compression de l'ensemble des scénarios de pannes d'un processeur comprenant des unités de calcul interconnectées par un réseau de communication présentant des symétries de topologie, chaque scénario de panne correspondant au nombre et à l'emplacement d'une ou plusieurs unités de calcul défaillantes et le procédé comprenant les étapes de:
réception ou détermination d'une ou plusieurs symétries de topologie;
détermination des scénarios équivalents au moyen desdites symétries de topologie, lesdits scénarios équivalents étant regroupés en classes d'équivalence;
chacune des classes d'équivalence de pannes étant associée à une solution d'allocation de ressources déterminant un placement spécifique des tâches des applications sur les unités de calcul et un routage spécifique des échanges de données sur le réseau de communication.

2. Procédé selon la revendication 1, la détermination des scénarios équivalents étant effectuée par application d'un moteur d'inférences.

3. Procédé selon la revendication 1, la détermination des scénarios équivalents comprenant l'association d'un ensemble d'identifiants à chaque scénario de panne.

4. Procédé selon la revendication 3, la détermination des scénarios équivalents comprenant l'association d'un identifiant unique à chaque scénario de panne.

5. Procédé selon la revendication 4, l'identifiant unique étant obtenu par concaténation des chaînes de caractères formant lesdits identifiants.

6. Procédé selon la revendication 1, les symétries comprenant une ou plusieurs rotations axiales autour d'un axe comprenant une ou plusieurs unités de calcul, selon des angles -90°/+90/+180° et un ou plusieurs déplacements ou décalages verticaux ou horizontaux.

7. Procédé selon la revendication 1, les scénarios de pannes équivalents étant déterminés par exploration combinatoire, ladite exploration combinatoire comprenant la construction d'un ou plusieurs arbres de classes d'équivalences.

8. Procédé selon l'une quelconque des revendications précédentes, comprenant en outre la création d'un fichier spécifiant l'allocation de ressources.

9. Procédé selon les revendications 1 à 8, comprenant en outre la détermination d'un taux de compression de l'espace des scénarios de pannes, le taux de compression étant associé au type d'architecture du processeur.

10. Procédé selon la revendication 1 pour la décompression de l'ensemble des scénarios de pannes d'un processeur, après le démarrage du processeur, comprenant en outre:
- la détermination d'une ou plusieurs pannes associées à une ou plusieurs unités de calcul au démarrage du processeur;
- la caractérisation du scénario de pannes correspondant;
- l'identification de la classe d'équivalence de pannes et de la solution d'allocation de ressources de calcul associée à ladite classe d'équivalence de pannes.

11. Procédé selon la revendication 10, comprenant en outre la reconfiguration du processeur démarré, la reconfiguration comprenant l'application au processeur de la solution d'allocation de ressources de calcul.

12. Procédé selon revendication 11, la reconfiguration s'effectuant au moment de, ou après, la survenue d'une ou plusieurs pannes d'une ou plusieurs unités de calcul du processeur afin de continuer l'exécution de l'application sur le processeur.

13. Procédé selon revendication 11, la reconfiguration s'effectuant avant la survenue d'une panne d'une ou plusieurs pannes d'une ou plusieurs unités de calcul du processeur de manière préventive, une ou plusieurs pannes étant simulée ou anticipée.

14. Procédé selon l'une quelconque des revendications précédentes, comprenant en outre le classement du processeur dans une gamme regroupant des processeurs dont le nombre d'unités de calcul défaillantes est identique.

15. Procédé selon l'une quelconque des revendications précédentes, une unité de calcul défaillante étant associée à un taux de défaillance ou de confiance d'exécution, ladite défaillance étant totale ou partielle.

16. Procédé selon l'une quelconque des revendications précédentes, comprenant en outre l'identification d'un ou de plusieurs liens symétriques à partir de la détermination ou de la réception d'une ou plusieurs symétries de topologie.

17. Un produit programme d'ordinateur, ledit programme d'ordinateur comprenant des instructions de code permettant d'effectuer les étapes du procédé selon l'une quelconque des revendications 1 à 16, lorsque ledit programme est exécuté sur un ordinateur.

18. Un système pour la compression ou la décompression de l'espace des scénarios de pannes d'un processeur, le système comprenant des moyens pour mettre en oeuvre les étapes du procédé selon l'une quelconque des revendications 1 à 16.

## Patentansprüche

1. Computerimplementiertes Verfahren für die Komprimierung der Gesamtheit von Fehlerszenarien eines Prozessors, der Recheneinheiten umfasst, die durch ein Kommunikationsnetz miteinander verbunden sind, das Topologiesymmetrien aufweist, wobei jedes Fehlerszenario der Anzahl und Stelle einer oder mehrerer fehlerhafter Recheneinheiten entspricht und das Verfahren die folgenden Schritte umfasst:
Empfangen oder Bestimmen einer oder mehrerer Topologiesymmetrien;
Bestimmen von äquivalenten Szenarien mittels der Topologiesymmetrien, wobei die äquivalenten Szenarien in Äquivalenzklassen zusammengefasst sind;
wobei jede der Fehleräquivalenzklassen mit einer Ressourcenzuweisungslösung verbunden ist, die eine spezifische Platzierung der Aufgaben der Anwendungen auf den Recheneinheiten und ein spezifisches Routing des Datenaustauschs auf dem Kommunikationsnetz bestimmt.

2. Verfahren nach Anspruch 1, wobei das Bestimmen von äquivalenten Szenarien durch Anwendung eines Inferenzmotors umgesetzt wird.

3. Verfahren nach Anspruch 1, wobei das Bestimmen von äquivalenten Szenarien das Verbinden einer Gesamtheit von Kennungen mit jedem Fehlerszenario umfasst.

4. Verfahren nach Anspruch 3, wobei das Bestimmen von äquivalenten Szenarien das Verbinden einer einmaligen Kennung mit jedem Fehlerszenario umfasst.

5. Verfahren nach Anspruch 4, wobei die einmalige Kennung durch Konkatenation der Zeichenketten, die die Kennungen bilden, erhalten wird.

6. Verfahren nach Anspruch 1, wobei die Symmetrien eine oder mehrere Axialdrehungen um eine Achse, die eine oder mehrere Recheneinheiten umfasst, nach Winkeln von -90°/+90/+180°, und eine oder mehrere vertikale oder horizontale Verschiebungen oder Versätze umfassen.

7. Verfahren nach Anspruch 1, wobei die äquivalenten Fehlerszenarien durch kombinatorische Exploration bestimmt werden, wobei die kombinatorische Exploration die Erstellung eines oder mehrerer Äquivalenzklassenbäume umfasst.

8. Verfahren nach einem der vorhergehenden Ansprüche, ferner umfassend die Erstellung einer Datei, die die Ressourcenzuweisung spezifiziert.

9. Verfahren nach Anspruch 1 bis 8, ferner umfassend das Bestimmen eines Komprimierungsverhältnisses des Fehlerszenarienraums, wobei das Komprimierungsverhältnis mit der Art der Architektur des Prozessors verbunden ist.

10. Verfahren nach Anspruch 1 zur Dekomprimierung der Gesamtheit von Fehlerszenarien eines Prozessors, nach dem Hochfahren des Prozessors, ferner umfassend:
- Bestimmen eines oder mehrerer Fehler, die mit einer oder mehreren Recheneinheiten verbunden sind, beim Hochfahren des Prozessors;
- Charakterisieren des entsprechenden Fehlerszenarios;
- Identifizieren der Fehleräquivalenzklasse und der Rechenressourcenzuweisungslösung, die mit der Fehleräquivalenzklasse verbunden ist.

11. Verfahren nach Anspruch 10, ferner umfassend die Neukonfiguration des hochgefahrenen Prozessors, wobei die Neukonfiguration die Anwendung der Rechenressourcenzuweisungslösung auf dem Prozessor umfasst.

12. Verfahren nach Anspruch 11, wobei die Neukonfiguration im Moment des oder nach dem Auftreten eines oder mehrerer Fehler einer oder mehrerer Recheneinheiten des Prozessors ausgeführt wird, um die Ausführung der Anwendung auf dem Prozessor fortzusetzen.

13. Verfahren nach Anspruch 11, wobei die Neukonfiguration auf präventive Weise vor dem Auftreten eines oder mehrerer Fehler einer oder mehrerer Recheneinheiten des Prozessors ausgeführt wird, wobei ein oder mehrere Fehler simuliert oder erwartet werden.

14. Verfahren nach einem der vorhergehenden Ansprüche, ferner umfassend die Klassifizierung des Prozessors in einem Bereich, der Prozessoren umfasst, deren Anzahl an defekten Recheneinheiten identisch ist.

15. Verfahren nach einem der vorhergehenden Ansprüche, wobei eine defekte Recheneinheit mit einer Defekt- oder Ausführungsvertrauensquote verbunden ist, wobei der Defekt total oder partiell ist.

16. Verfahren nach einem der vorhergehenden Ansprüche, ferner umfassend die Identifizierung einer oder mehrerer symmetrischer Beziehungen basierend auf der Bestimmung oder des Empfangs einer oder mehrerer Topologiesymmetrien.

17. Computerprogrammprodukt, wobei das Computerprogramm Code-Anweisungen umfasst, die es ermöglichen, die Schritte des Verfahrens nach einem der Ansprüche 1 bis 16 durchzuführen, wobei das Programm auf einem Computer ausgeführt wird.

18. System für die Komprimierung oder die Dekomprimierung des Fehlerszenarienraums eines Prozessors, wobei das System Mittel zur Umsetzung der Verfahrensschritte nach einem der Ansprüche 1 bis 16 umfasst.

## Claims

1. A method implemented by computer for compressing all the fault scenarios of a processor comprising computation units interconnected by a communication network having topology symmetries, each fault scenario corresponding to the number and the location of one or more failing computation units, and the method comprising the steps of:
reception or determination of one or more topology symmetries;
determination of the equivalent scenarios by means of said topology symmetries, said equivalent scenarios being grouped together in equivalence classes;
each of the fault equivalence classes being associated with a resource allocation solution determining a specific mapping of the tasks of the applications on the computation units and a specific routing of the data exchanges over the communication network.

2. The method according to Claim 1, the determination of the equivalent scenarios being performed by application of an inference engine.

3. The method according to Claim 1, the determination of the equivalent scenarios comprising the association of a set of identifiers with each fault scenario.

4. The method according to Claim 3, the determination of the equivalent scenarios comprising the association of a unique identifier with each fault scenario.

5. The method according to Claim 4, the unique identifier being obtained by concatenation of the character strings forming said identifiers.

6. The method according to Claim 1, the symmetries comprising one or more axial rotations about an axis comprising one or more computation units, according to angles -90°/+90/+180°, and one or more vertical or horizontal displacements or shifts.

7. The method according to Claim 1, the equivalent fault scenarios being determined by combinatorial exploration, said combinatorial exploration comprising the construction of one or more equivalence class trees.

8. The method according to any one of the preceding claims, further comprising the creation of a file specifying the allocation of resources.

9. The method according to Claims 1 to 8, further comprising the determination of a compression rate of the fault scenario space, the compression rate being associated with the type of architecture of the processor.

10. The method according to Claim 1 for decompressing all the fault scenarios of a processor, after the start-up of the processor, further comprising:
- the determination of one or more faults associated with one or more computation units on starting up the processor;
- the characterization of the corresponding fault scenario;
- the identification of the fault equivalence class and of the computation resource allocation solution associated with said fault equivalence class.

11. The method according to Claim 10, further comprising the reconfiguration of the processor started up, the reconfiguration comprising the application to the processor of the computation resource allocation solution.

12. The method according to Claim 11, the reconfiguration being performed at the moment of, or after, the occurrence of one or more faults of one or more computation units of the processor in order to continue the execution of the application on the processor.

13. The method according to Claim 11, the reconfiguration being performed before the occurrence of one or more faults of one or more computation units of the processor preventively, one or more faults being simulated or anticipated.

14. The method according to any one of the preceding claims, further comprising the classification of the processor in a range grouping together processors with an identical number of failing computation units.

15. The method according to any one of the preceding claims, a failing computation unit being associated with a failure rate or confidence of execution rate, said failure being total or partial.

16. The method according to any one of the preceding claims, further comprising the identification of one or more symmetrical links from the determination or the reception of one or more topology symmetries.

17. A computer program product, said computer program comprising code instructions making it possible to perform the steps of the method according to any one of Claims 1 to 16, when said program is run on a computer.

18. A system for compressing or decompressing the fault scenario space of a processor, the system comprising means for implementing the steps of the method according to any one of Claims 1 to 16.
